# EUROPEAN PATENT APPLICATION

(11) **EP 2 059 063 A1**
(43) Date of publication of application: **13.05.2009**
(21) Application number: 08168903.6
(22) Date of filing: 12.11.2008
(51) Int. Cl.: H04R 1/16

(54) **Electronic component, electronic component unit, speaker, and mobile terminal including speaker**

(30) Priority: 12.11.2007 JP 2007293134
(71) Applicant: Panasonic Corporation, Kadoma-shi Osaka 571-8501 (JP)
(72) Inventor: Suzuki, Shinya, Osaka 540-6207 (JP); Suzuki, Shouji, Osaka 540-6207 (JP)
(74) Representative: Grünecker, Kinkeldey, Stockmair & Schwanhäusser Anwaltssozietät

(57) **Abstract**

To provide an electronic component, an electronic component unit, a speaker, and a mobile terminal including the speaker which can realize the stable electrical conduction. An electronic component includes a frame, an electric circuit which is provided on the frame, a coil spring which is electrically connected to the electric circuit, and a rib which is provided on the frame and is inserted into the coil spring.

## Description

### BACKGROUND

The present invention relates to an electronic component, an electronic component unit, a speaker and a mobile terminal having the speaker, and more particularly to an improvement of the structure which is electrically connected to a wiring board using a coil spring.

In general, the speaker structure incorporated in electronic equipment such as a mobile terminal includes a wiring board which is mounted on and fixed to a frame of the electronic equipment and a speaker which is arranged between the wiring board and the frame and is electrically connected to the wiring board via conductive leaf springs. For example, the leaf springs extend and shrink in the thickness direction of the frame of the electronic equipment relative to the wiring board, and bias the speaker toward an inner wall of the frame of the electronic equipment so as to fix a position of the speaker. As the conventional speaker structure, for example, the structures disclosed in following patent documents are known.

[Patent Document 1] JP-UM-A-3-123398
[Patent Document 2] JP-A-2001-119775
[Patent Document 3] JP-B-3017180

Currently, in miniaturizing electronic equipment which includes a mobile terminal, even when a thickness of a frame of the electronic equipment is decreased or even when a thickness of a speaker per se is decreased, the reduction of a thickness of a terminal portion including leaf springs is limited. Further, when the leaf springs are arranged at positions displaced from positions between the wiring board and the speaker, in a state that the positional relationship between the speaker and the leaf springs is viewed in a plan view in the thickness direction of the electronic equipment, a region where the speaker and the leaf springs are arranged is substantially increased. Accordingly, such arrangement of the leaf springs is not suitable for the miniaturization of the frame. In view of the above, the use of coil springs which can relatively easily realize the miniaturization thereof in place of the leaf springs is considered. In such constitution, the coil springs are arranged between the wiring board and the speaker and both of the wiring board and the speaker are electrically connected with each other via the coil springs. However, when the coil springs are housed between the wiring board and the speaker, a shape of the coil spring collapses due to a repulsive force or the coil spring is bent in the direction away from an axial direction of the coil spring, that is, a deformation which is called "collapse" occurs. Accordingly, there exists a possibility that the electrical connection between the coil spring and the wiring board becomes unstable thus giving rise to the connection failure.

### SUMMARY

Accordingly, it is an object of the present invention to provide an electronic component, an electronic component unit, a speaker, and a mobile terminal having the speaker which can realize the stable electrical conduction.

To achieve the above-mentioned object of the present invention, the electronic component, the electronic component unit, the speaker, and the mobile terminal including the speaker are constituted as follows.
(1) The present invention is directed to an electronic component which includes a frame, an electric circuit which is provided on the frame, a coil spring which is electrically connected to the electric circuit, and a rib which is provided on the frame and is inserted into the coil spring.
(2) In the electronic component having the above-mentioned constitution (1), a projecting length of the rib is set smaller than a length of the coil spring in a non-extended and non-shrunken state.
(3) In the electronic component having the above-mentioned constitution (1) or (2), a plurality of the ribs are provided on the frame.
(4) The present invention is directed to an electronic component unit which includes a frame, an electric circuit which is provided on the frame, a coil spring which is electrically connected to the electric circuit, a rib which is provided on the frame and is inserted into the coil spring, and a wiring board which is electrically connected to the coil spring.
(5) In the electronic component unit having the above-mentioned constitution (4), a projecting length of the rib is smaller than a length of the coil spring which is in a non-extended and non-shrunken state.
(6) In the electronic component unit having the above-mentioned constitution (4) or (5), a plurality of the ribs are provided on the frame.
(7) In the electronic component unit having any one of the above-mentioned constitutions (4) to (6), a distal end portion of the rib is brought into contact with the wiring board when the coil spring is in a shrunken state,
(8) The present invention is directed to a speaker which includes a frame, an electric circuit which is provided on the frame, a coil spring which is electrically connected to the electric circuit, and a rib which is provided on the frame and is inserted into the coil spring.
(9) In the speaker having the above-mentioned constitution (8), a height of the rib projecting from the frame is smaller than a length of the coil spring which is in a non-extended and non-shrunken state.
(10) In the speaker having the above-mentioned constitution (8) or (9), a plurality of the ribs are provided on the frame.
(11) The present invention is directed to a mobile terminal including the speaker described in any one of the above-mentioned constitutions 8 to 10.

According to the constitution of the present invention, the rib is inserted into the coil spring which electrically connects the electronic component and the wiring board. Therefore, when the coil spring is assembled between the electronic component and the wiring board in a shrunken state, the coil spring is held by the rib, and it is possible to prevent the coil spring from being displaced from the axial direction along which the coil spring extends and shrinks. Accordingly, there is no possibility that the coil spring generates the irregular deformation such as collapse and hence, the coil spring and the wiring board can be made electrically conductive with each other in a stable manner thus preventing the occurrence of the connection failure.

According to the present invention, it is possible to provide the electronic component, the electronic component unit, the speaker, and the mobile terminal including the speaker which can realize the stable electric conduction.

### BRIEF DESCRIPTION OF THE DRAWINGS

The above objects and advantages of the present invention will become more apparent by describing in detail preferred exemplary embodiments thereof with reference to the accompanying drawings, wherein:
Fig. 1 is a view showing the cross-sectional constitution of an electronic component and an electronic component unit according to the present invention;
Fig. 2 is a view showing a state in which a speaker is taken out from a terminal housing of a mobile terminal;
Fig. 3 is a perspective view of the whole speaker;
Fig. 4A is a side view of the speaker shown in Fig. 3 as viewed in the direction indicated by an arrow X, and Fig. 4B is a plan view of the speaker shown in Fig. 3 as viewed in the direction indicated by an arrow Y;
Fig. 5 is a partially enlarged view of the speaker shown in Fig. 4B;
Fig. 6A to Fig. 6D are views showing modifications of the constitution of the speaker according to the present invention; and
Fig. 7A to Fig. 7C are cross-sectional views showing modifications of a coil spring.

### DETAILED DESCRIPTION OF EXEMPLARY EMBODIMENTS

Hereinafter, embodiments of the present invention are explained in detail in conjunction with drawings.

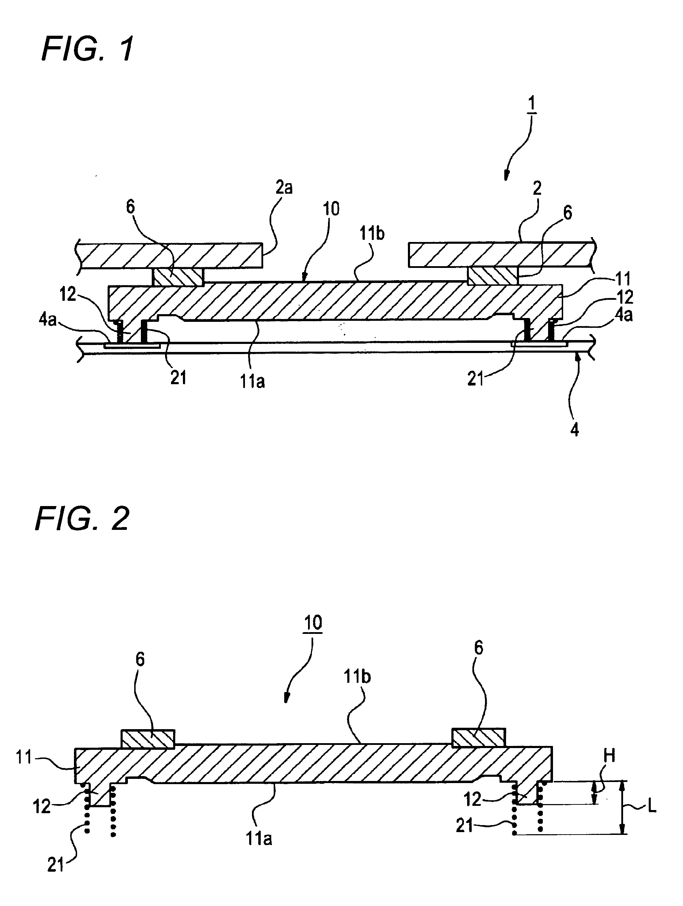

Fig. 1 is a view showing the cross-sectional constitution of an electronic component and an electronic component unit according to the present invention. Here, in the embodiment explained hereinafter, as one example of the electronic component, the constitution of a speaker of a mobile terminal is explained. However, the electronic component is not limited to the speaker, and the present invention is applicable to other electronic component provided that such an electronic component is configured to be used in a state that the electronic component is connected with a wiring board used in general.

The mobile terminal 1 includes a terminal housing 2, a wiring board 4 which is incorporated in the terminal housing 2, and a speaker 10 which is electrically connected to the wiring board 4. A drive circuit, a control circuit and an information processing part of the mobile terminal 1 and wiring circuits of these parts are formed on the wiring board 4.

The terminal housing 2 is formed by resin molding and has a substantially rectangular parallelepiped shape, for example, and has an inner hollow space. In a portion of a wall portion of the terminal housing 2 which partitions the mobile terminal 1 from the outside, a sound emitting hole 2a for emitting sounds to the outside when the mobile terminal 1 is used is opened.

The wiring board 4 may be formed of an electronic wiring board used in general. For example, a printed wiring board which forms wiring by patterning on a substrate or the like can be used. Further, although not shown in the drawing, to the wiring board 4, other electronic circuit parts and other wiring components may be connected. On a speaker-side surface of the wiring board 4 (on an upper surface of the wiring board 4 in Fig. 1), connection terminal portions 4a which constitute terminals to be connected to a speaker side are formed.

The speaker 10 is arranged between a wall portion of the terminal housing 2 and the wiring board 4. The speaker 10 includes a plate-shaped frame 11. The frame 11 has a wiring-board-side surface 11a which faces a side opposite to the sound emitting hole 2a and a sound-emitting-side surface 11b which faces the sound emitting hole 2a on a side opposite to the wiring-board-side surface 11a. Although not shown in the drawing, in the inside of the frame 11, a diaphragm which constitutes the speaker, a vibration part such as a voice coil which vibrates the diaphragm, and an electric circuit which supplies an electric current to the vibration part are formed.

A cushion member 6 such as a sponge is arranged between the sound-emitting-side surface 11b of the speaker 10 and the wall portion of the terminal housing 2 so as to make the frame 11 and the wall portion of the terminal housing 2 separated from each other.

On the frame 11 of the speaker 10, a plurality of (two pieces in Fig. 1) columnar-shaped ribs 12 which project perpendicular to the wiring-board-side surface 11a of the frame 11 are formed. The ribs 12 are inserted into coil springs 21 which are made of a conductive material. The coil spring 21 has a resilient function which allows the coil spring 21 to extend and shrink in the axial direction (in the vertical direction in Fig. 1). In a state that the speaker 10 is incorporated in the terminal housing 2, distal end portions of the ribs 12 are brought into contact with the wiring board 4. Here, the coil spring 21 assumes a shrunken state. Due to a biasing force of the coil spring 21, the frame 11 of the speaker 10 is brought into pressure contact with and is held on a wall portion side of the terminal housing 2.

Fig. 2 is a view showing a state in which the speaker is taken out from the terminal housing of the mobile terminal. In a state that the coil spring 21 into which the rib 12 is inserted neither extends nor shrinks, a height H of the rib 12 which projects from the wiring-board-side surface 11 a of the frame 11 is set smaller than a length L of the coil spring 21 which is in a non-extended and non-shrunken state. In other words, the height H of the rib 12 corresponds to a length of the coil spring 21 when the coil spring 21 shrinks due to a contact of the coil spring 21 with the wiring board 4 in a state that the speaker 10 is provided on the terminal housing 2 of the mobile terminal 1. That is, based on the height H of the rib 12, a shrinkage quantity of the coil spring 21 when the speaker 10 is provided on the terminal housing 2 of the mobile terminal 1 can be decided.

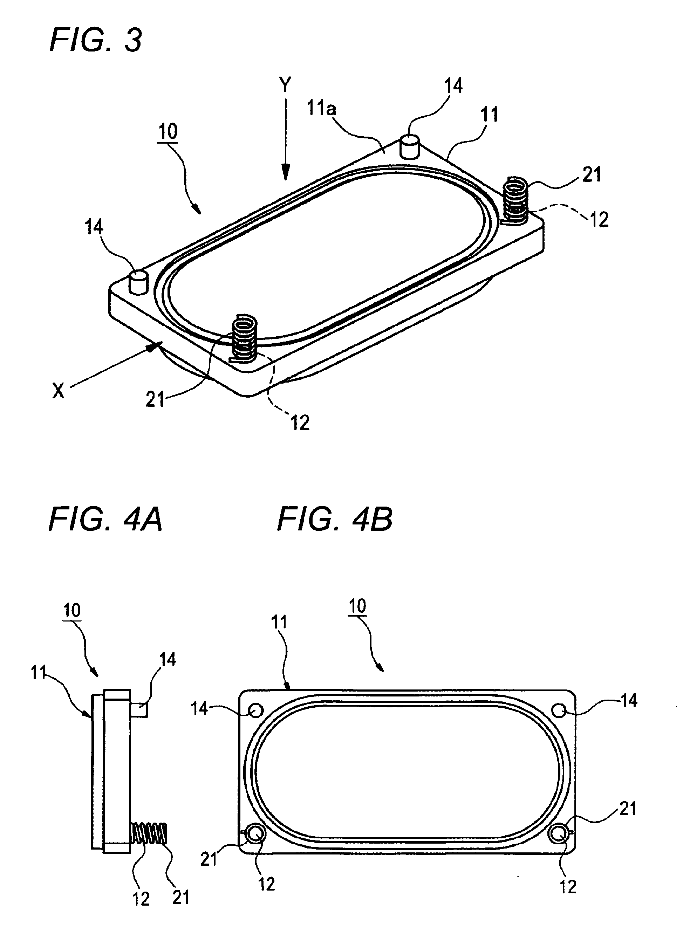

Fig. 3 is a perspective view of the whole speaker according to this embodiment. Fig. 4A is a side view of the speaker shown in Fig. 3 as viewed in the direction indicated by an arrow X, and Fig. 4B is a plan view of the speaker shown in Fig. 3 as viewed in the direction indicated by an arrow Y. In Fig. 3, an upper surface of the frame 11 of the speaker 10 constitutes the wiring-board-side surface 11a and a lower surface of the frame 11 constitutes the sound-emitting-side surface 11b.

In this embodiment, the frame 11 has an approximately rectangular parallelepiped shape, and two ribs 12 which are inserted into the coil springs 21 are respectively formed on the wiring-board-side surface 11a in the vicinity of two corner portions. Further, in the vicinity of remaining two corner portions, holding ribs 14 which are not inserted into the coil springs 21 are formed on the wiring board-side surface 11a. The holding rib 14 has a shape approximately equal to the shape of the rib 12, and a projecting height of the holding rib 14 from the wiring-board-side surface 11a of the frame 11 is equal to the height H of the rib 12 (see Fig. 2). Accordingly, in a state that the speaker 10 is assembled in the terminal housing 2 of the mobile terminal 1, distal end portions of the holding ribs 14 are brought into contact with the wiring board 4 in the same manner as the ribs 12. The holding ribs 14 have a function of preventing the frame 11 assembled in the terminal housing 2 from rattling with respect to the wiring board 4. Here, the holding rib 14 may have a shape different from the shape of the rib 12. Further, one or three or more holding ribs 14 may be formed.

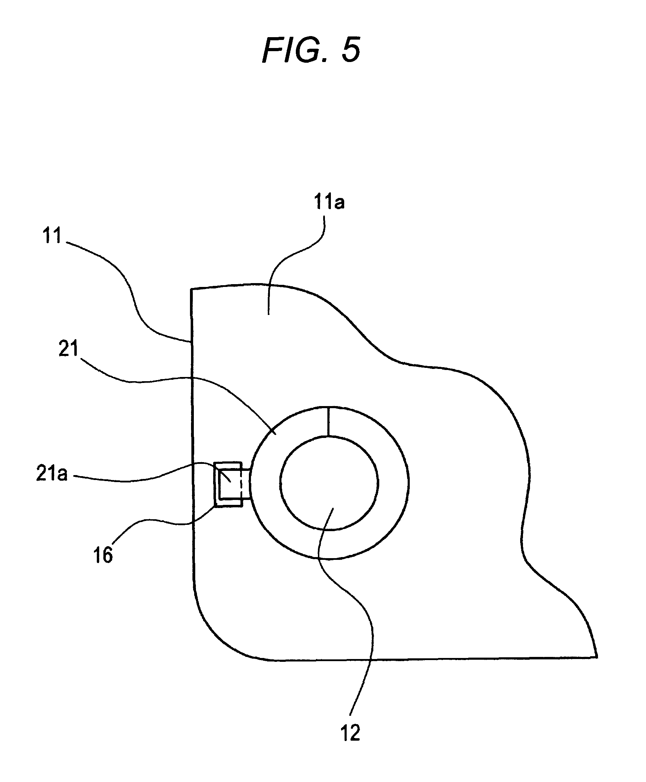

Fig. 5 is a partially enlarged view of the speaker shown in Fig. 4B. The coil spring 21 into which the rib 12 is inserted is adhered to the conductive portion 16 which is formed on the wiring-board-side surface 11a in an exposed manner by soldering or the like for establishing the electric connection between an axially end portion 21 a on the frame 11 side and the electric circuit arranged in the inside of the frame 11.

According to the constitution of the mobile terminal 1 of this embodiment, the ribs 12 are inserted into the coil springs 21 which electrically connect the speaker 10 and the wiring board 4. Accordingly, when the coil spring 21 is assembled between the speaker 10 and the wiring board 4 in a shrunken state, the coil springs 21 are held by the ribs 12 and hence, it is possible to prevent the coil spring 21 from being displaced from the axial direction along which the coil spring 21 extends and shrinks. Accordingly, there exists no possibility that the irregular deformation such as collapse of the coil spring 21 is generated and hence, the coil spring 21 and the wiring board can be surely electrically connected with each other thus preventing the occurrence of the connection failure.

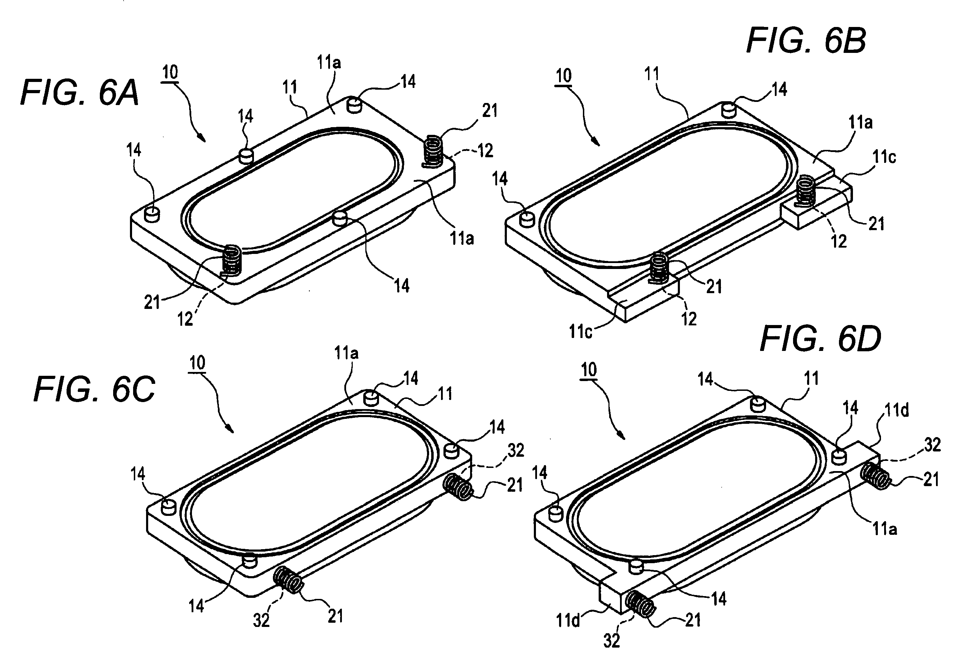

Fig. 6A to Fig. 6D are views showing modifications of the constitution of the speaker according to the present invention. Here, in the modifications explained hereinafter, with respect to parts having the constitution and the manner of operation substantially equal to the constitutions and the manner of operation of the parts explained in the above-mentioned embodiment or the like, by giving the same numerals or corresponding numerals to the parts in the drawings, their explanations are simplified or omitted. In the speaker 10 shown in Fig. 6A, the holding ribs 14 are respectively formed on approximately center portions of respective long-side portions of the wiring-board-side surface 11a of the frame 11. The number of formed holding rib 14 is not particularly limited. By increasing the number of formed ribs 14, it is possible to make the speaker 10 more stable when the speaker 10 is assembled in the terminal housing 2 thus surely preventing rattles of the speaker 10.

In the speaker 10 shown in Fig. 6B, end portions of one long-side portion of the frame 11 have extending portions 11c which extend parallel to the wiring-board-side surface 11 a, and ribs 12 are respectively formed on surfaces of the extending portions 11c parallel to the wiring-board-side surface 11 a in a perpendicularly projecting manner. The ribs 12 are inserted into the coil springs 21 in the same manner as the above-mentioned embodiment. Due to such constitution, the ribs 12 can be also formed on surfaces other than the wiring-board-side surface 11a thus enhancing the degree of freedom in designing the frame 11.

In the speaker 10 shown in Fig. 6C, ribs 32 are formed on one peripheral side surface out of four peripheral side surfaces of the wiring-board-side surface 11a of the frame 11 in a perpendicularly projecting manner, and the ribs 32 are inserted into the coil springs 21 respectively. Due to such constitution, it is possible to change a shape of the wiring board incorporated in the terminal housing and a position of the sound emitting hole formed in the speaker and hence, the degree of freedom in designing the mobile terminal can be enhanced.

In the speaker 10 shown in Fig. 6D, both end portions of one long-side side edge portion of the wiring-board-side surface 11a of the frame 11 respectively have extending portions 11d which extend parallel to the wiring-board-side surface 11a. The ribs 32 are provided on one side surfaces of extending portions 11d which are perpendicular to the wiring-board-side surface 11a, and the ribs 32 are respectively inserted into the coil springs 21. Due to such constitution, it is possible to change a shape of the wiring board which is incorporated in the terminal housing and a position of the sound emitting hole formed in the speaker and hence, the degree of freedom in designing the mobile terminal can be enhanced.

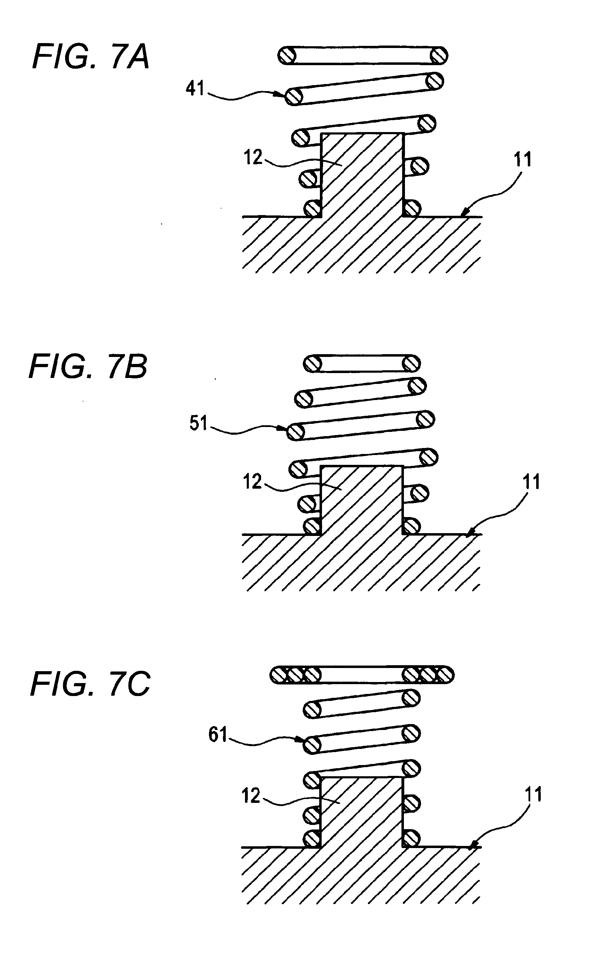

Fig. 7A to Fig. 7C are cross-sectional views showing modifications of the coil spring.
A coil spring 41 shown in Fig. 7A is formed into a shape such that a winding diameter of the coil spring 41 is gradually increased toward the wiring board side (the upper side in Fig. 7A). Due to such a shape, the electric connection between the coil spring 41 and the wiring board can be easily ensured. Further, when the coil spring 41 assumes a shrunken state, since the winding diameter of an end portion of the coil spring on a side of the frame 11 is set small, it is possible to obtain an advantageous effect that drawbacks such as collapse hardly occurs.

A coil spring 51 shown in Fig. 7B is formed into a shape such that a winding diameter of an axially center portion of the coil spring 51 is set larger than winding diameters of end portions of the coil spring 51. Due to such a shape, it is possible to obtain an advantageous effect that, when the coil spring 51 shrinks, the coil spring 51 is hardly displaced from the axial direction thereof (vertical direction in Fig. 7B).

A coil spring 61 shown in Fig. 7C is formed into a shape such that an end portion of the coil spring 61 on the wiring board side (upper side of the coil spring 61 in Fig. 7C) is wound plural times in an overlapped manner in the radial direction. Accordingly, the end portion of the coil spring 61 on the wiring board side can have a large contact area with respect to the wiring board and hence, it is possible to bring the coil spring 61 into contact with the wiring board more reliably. Here, the coil spring 61 is not limited to the shapes described in the above-mentioned embodiments or shapes shown in Fig. 7, and the shape of the coil spring can be suitably changed provided that the wiring board 4 and the coil spring can be surely electrically connected with each other.
Although the invention has been illustrated and described for the particular preferred embodiments, it is apparent to a person skilled in the art that various changes and modifications can be made on the basis of the teachings of the invention. It is apparent that such changes and modifications are within the spirit, scope, and intention of the invention as defined by the appended claims.
The present application is based on Japan Patent Application No. 2007-293134 filed on November 12, 2007, the contents of which are incorporated herein for reference.

## Claims

1. An electronic component, comprising:
a frame;
an electric circuit which is provided on the frame;
a coil spring which is electrically connected to the electric circuit; and
a rib which is provided on the frame and is inserted into the coil spring.

2. The electronic component according to claim 1, wherein a projecting length of the rib is set smaller than a length of the coil spring which is in a non-extended and non-shrunken state.

3. The electronic component according to claim 1, wherein a plurality of the ribs are provided on the frame.

4. An electronic component unit, comprising:
a frame;
an electric circuit which is provided on the frame;
a coil spring which is electrically connected to the electric circuit;
a rib which is provided on the frame and is inserted into the coil spring; and
a wiring board which is electrically connected to the coil spring.

5. The electronic component unit according to claim 4, wherein a projecting length of the rib is smaller than a length of the coil spring which is in a non-extended and non-shrunken state.

6. The electronic component unit according to claim 4, wherein a plurality of the ribs are provided on the frame.

7. The electronic component unit according to claim 4, wherein a distal end portion of the rib is brought into contact with the wiring board when the coil spring is in a shrunken state.

8. A speaker, comprising:
a frame;
an electric circuit which is provided on the frame;
a coil spring which is electrically connected to the electric circuit; and
a rib which is provided on the frame and is inserted into the coil spring.

9. The speaker according to claim 8, wherein a height of the rib projecting from the frame is set smaller than a length of the coil spring which is in a non-extended and non-shrunken state.

10. The speaker according to claim 8, wherein a plurality of the ribs are provided on the frame.

11. A mobile terminal including the speaker according to claim 8.
